Europäisches Patentamt

European Patent Office

Office européen des brevets

(19)

(11) Veröffentlichungsnummer: **0 608 704 A2**

(12) **EUROPÄISCHE PATENTANMELDUNG**

(21) Anmeldenummer: **94100339.4**

(22) Anmeldetag: **12.01.94**

(51) Int. Cl.5: **H03L 7/197**, H03K 23/68

(30) Priorität: **29.01.93 DE 4302438**

(43) Veröffentlichungstag der Anmeldung:
**03.08.94 Patentblatt 94/31**

(84) Benannte Vertragsstaaten:
**AT CH DE ES FR GB IT LI PT**

(71) Anmelder: **Blaupunkt-Werke GmbH**
**Robert-Bosch-Strasse 200**
**D-31139 Hildesheim(DE)**

(72) Erfinder: **Chahabadi, Djahanyar, Dr.**
**Am Krümpel 1B**
**D-31139 Hildesheim(DE)**

(74) Vertreter: **Eilers, Norbert, Dipl.-Phys.**
**Blaupunkt-Werke GmbH**
**Patente und Lizenzen**
**Postfach 77 77 77**
**D-31132 Hildesheim (DE)**

(54) **Schaltungsanordnung zur Frequenzteilung durch eine ungerade Zahl.**

(57) Bei einer Schaltungsanordnung zur Teilung der Frequenz eines zugeführten Signals durch eine ungerade Zahl wird zunächst durch eine halbzahlige Frequenzteilung ein weiteres Signal abgeleitet, dessen Frequenz anschließend halbiert wird. Vorzugsweise wird zur halbzahligen Frequenzteilung abwechselnd eine Frequenzteilung durch die unterhalb der Halbzahl liegende ganze Zahl und eine Frequenzteilung durch die oberhalb der Halbzahl liegende ganze Zahl durchgeführt, wobei eine Umschaltung in Abhängigkeit vom Ausgangssignal erfolgt.

Fig.1

EP 0 608 704 A2

Rank Xerox (UK) Business Services
(3.10/3.09/3.3.4)

Die Erfindung geht aus von einer Schaltungsanordnung nach der Gattung des Hauptanspruchs.

Für Zwecke der Senderabstimmung wird in Rundfunkempfängern häufig eine Phasenregelschleife (PLL-Schaltung) eingesetzt, bei welcher die Frequenz des Signals eines steuerbaren Oszillators geteilt und das Signal mit der geteilten Frequenz in einem Phasendetektor mit dem Signal eines Referenz-Oszillators verglichen wird, wodurch eine dem steuerbaren Oszillator zuführbare Abstimmspannung erzeugt wird. Abhängig von der gewählten Frequenz des Referenz-Oszillators ist zur Erzielung des gewünschten Abstimmrasters häufig eine ungeradzahlige Frequenzteilung erforderlich. Insbesondere wird hierbei für eine analoge Weiterverarbeitung des bezüglich der Frequenz geteilten Signals aus Leistungsgründen ein Tastverhältnis von nahezu 1 gefordert.

Aufgabe der vorliegenden Erfindung ist es, eine Frequenzteilung durch eine ungerade Zahl bei einem Tastverhältnis von nahezu 1 mit einfachen Mitteln zu ermöglichen.

Die erfindungsgemäße Schaltungsanordnung mit den kennzeichnenden Merkmalen des Hauptanspruchs hat den Vorteil, daß mit Hilfe von einfachen in der digitalen Schaltungstechnik üblichen Schaltungen eine Frequenzteilung durch eine ungerade Zahl möglich wird, wobei das Tastverhältnis des bezüglich der Frequenz geteilten Signals, im folgenden Ausgangssignal genannt, nahezu 1 ist.

Durch die in den Unteransprüchen aufgeführten Maßnahmen sind vorteilhafte Weiterbildungen und Verbesserungen der im Hauptanspruch angegebenen Erfindung möglich.

Eine vorteilhafte Ausführungsform gestattet die Programmierung beliebiger ungeradzahliger Teilerverhältnisse, während eine andere vorteilhafte Ausführungsform die Programmierung sowohl geradzahliger als auch ungeradzahliger Teilerverhältnisse ermöglicht.

Ausführungsbeispiele der Erfindung sind in der Zeichnung anhand mehrerer Figuren dargestellt und in der nachfolgenden Beschreibung näher erläutert. Es zeigt:

Fig. 1     ein Blockschaltbild eines ersten Ausführungsbeispiels,

Fig. 2     ein Blockschaltbild einer an sich bekannten PLL-Schaltung und

Fig. 3     ein Blockschaltbild eines zweiten Ausführungsbeispiels.

Gleiche Teile sind in den Figuren mit gleichen Bezugszeichen versehen.

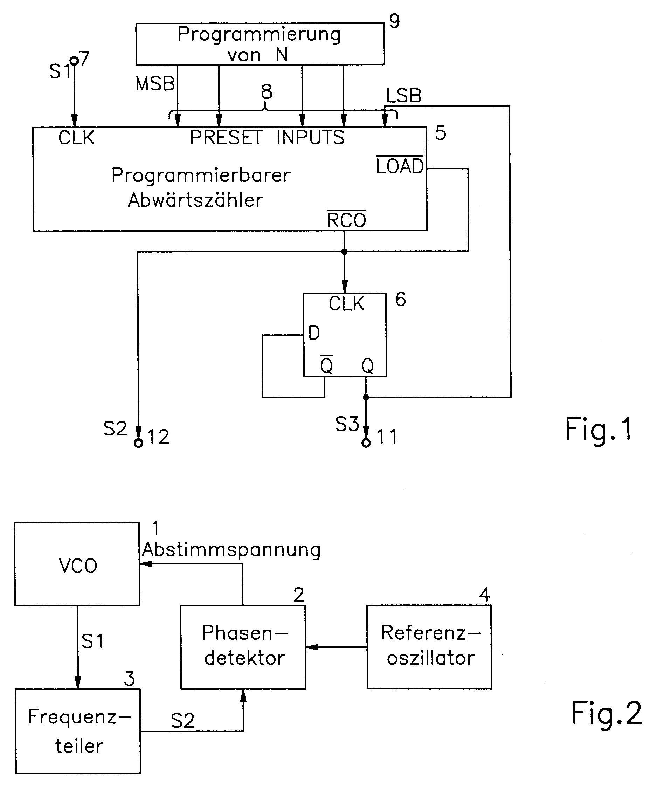

Eine bekannte, häufig verwendete PLL-Schaltung zur Abstimmung eines Rundfunkempfängers ist in Fig. 2 als Blockschaltbild dargestellt. Sie enthält einen steuerbaren Oszillator 1, dem von einem Phasendetektor 2 eine Abstimmspannung zuführbar ist. Das Ausgangssignal S1 des steuerbaren Oszillators 1 wird einem Frequenzteiler 3 zugeführt, dessen Ausgangssignal S3 in einem einstellbaren Teilerverhältnis zum Signal S1 steht.

Das Signal S3 wird im Phasendetektor 2 mit dem Ausgangssignal eines Referenz-Oszillators 4 verglichen, wodurch die Abstimmspannung erzeugt wird. Dabei kann es je nach Auslegung der Frequenzen im einzelnen erforderlich sein, mit dem Frequenzteiler 3 auch ungeradzahlige Teilerverhältnisse zu realisieren.

Fig. 1 stellt ein erfindungsgemäßes Ausführungsbeispiel eines Frequenzteilers 3 (Fig. 2) dar, das von einem programmierbaren Abwärtszähler 5 und einem Flip-Flop 6 gebildet wird. Das Signal S1 wird über einen Eingang 7 einem Takteingang CLK des Abwärtszählers 5 zugeführt. Der Abwärtszähler 5 kann über ein Signal an einem Eingang $\overline{LOAD}$ auf einen über Setzeingänge 8 zuführbaren Wert gesetzt werden. Dieser Wert, im folgenden Vorgabewert genannt, wird von einer Einrichtung 9 zugeführt, die beispielsweise von einem Ausgangsregister eines Mikrocomputer gebildet ist, der unter anderem zur Sendereinstellung dient.

Ein Ausgang $\overline{RCO}$ (Ripple Carry Out) des Abwärtszählers 5 ist an den Eingang $\overline{LOAD}$ angeschlossen, so daß der Abwärtszähler 5 bei Erreichen des Zählerstandes Null auf den Vorgabewert gesetzt wird. Der Ausgang $\overline{RCO}$ ist ferner mit dem Takteingang CLK eines Flip-Flops 6 verbunden, dessen invertierender Eingang $\overline{Q}$ an den Dateneingang D angeschlossen ist, so daß das Flip-Flop 6 als Zweiteiler arbeitet. Der Ausgang Q des Flip-Flops 6 bildet einen Ausgang 11 des Frequenzteilers, an welchem das Ausgangssignal S3 abnehmbar ist. Der Ausgang Q des Flip-Flops 6 ist ferner mit der geringstwertigen Binärstelle LSB der Programmiereingänge 8 verbunden.

In Abhängigkeit vom jeweiligen Pegel des Ausgangssignals erfolgt durch den Abwärtszähler jeweils eine Teilung der Frequenz des Signals S1 durch 2N + 1 oder durch 2N. Erreicht der Abwärtszähler 5, beginnend von dem jeweiligen Vorgabewert, den Wert 0, wird das Flip-Flop 6 getriggert, so daß das Ausgangssignal seinen Pegel wechselt und damit das jeweils andere Teilerverhältnis des Abwärtszählers 5 eingestellt wird. Im Mittel ergibt sich somit ein Teilerverhältnis des Abwärtszählers 5 von $(2N + \frac{1}{2})$. Das Flip-Flop 6 teilt die Frequenz des entstandenen Signals S2, das an einem weiteren Ausgang 12 abnehmbar ist, durch 2 und erzeugt somit das Ausgangssignal S3 mit einem Tastverhältnis von 2N/(2N + 1), das für große N gegen 1 strebt. Insgesamt wird die Frequenz des Signals S1 somit durch 4N + 1 geteilt.

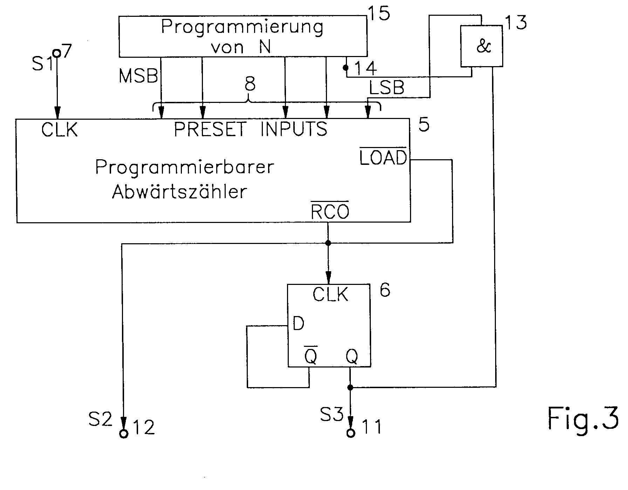

Gegenüber dem Ausführungsbeispiel nach Fig. 1 ist bei dem Ausführungsbeispiel nach Fig. 3 zwischen dem Ausgang Q des Flip-Flops 6 und der geringstwertigen Binärstelle der Programmiereingänge 8 des Abwärtszählers 5 eine Und-Schaltung 13 zwischengeschaltet, die von einem weiteren Ausgang 14 einer Einrichtung 15 steuerbar ist, die ansonsten die weiteren Binärstellen für die Programmiereingänge 8 zur Verfügung stellt und somit das Teilerverhältnis steuert.

In Abhängigkeit von dem Pegel an dem zusätzlichen Ausgang 14 erfolgt die Frequenzteilung durch den Abwärtszähler 5 in Abhängigkeit oder unabhängig vom Ausgangssignal S3. Ist die Und-Schaltung 13 für das Ausgangssignal S3 durchlässig, so arbeitet die Schaltungsanordnung nach Fig. 3 wie die Schaltungsanordnung nach Fig. 1. Wird jedoch mit Hilfe der Und-Schaltung 13 die Zuführung des Ausgangssignals zu der geringstwertigen Binärstelle der Programmiereingänge 8 gesperrt, so ergibt sich ein geradzahliges Teilerverhältnis. Mit der in Fig. 3 dargestellten Schaltungsanordnung lassen sich deshalb neben den Teilerverhältnissen von M = 4N + 1 auch Teilerverhältnisse von M = 4N realisieren.

**Patentansprüche**

1. Schaltungsanordnung zur Teilung der Frequenz eines zugeführten Signals durch eine ungerade Zahl, dadurch gekennzeichnet, daß zunächst durch eine halbzahlige Frequenzteilung ein weiteres Signal abgeleitet wird, dessen Frequenz anschließend halbiert wird.

2. Schaltungsanordnung nach Anspruch 1, dadurch gekennzeichnet, daß zur halbzahligen Frequenzteilung abwechselnd eine Frequenzteilung durch die unterhalb der Halbzahl liegende ganze Zahl und eine Frequenzteilung durch die oberhalb der Halbzahl liegende ganze Zahl durchgeführt wird, wobei eine Umschaltung in Abhängigkeit vom Ausgangssignal erfolgt.

3. Schaltungsanordnung nach Anspruch 2, dadurch gekennzeichnet, daß zur halbzahligen Frequenzteilung durch $(2N + \frac{1}{2})$ abwechselnd eine Frequenzteilung durch $(2N + 1)$ und durch $2N$ durchgeführt wird, wobei N eine ganze Zahl ist.

4. Schaltungsanordnung nach Anspruch 2, dadurch gekennzeichnet, daß das Signal dem Takteingang eines programmierbaren Abwärtszählers (5) zuführbar ist, dessen Ausgang mit dem Takteingang eines als Zweiteiler geschalteten Flip-Flops (6) verbunden ist, daß der Ausgang des Abwärtszählers (5) ferner mit einem Ladeeingang des Abwärtszählers (5) verbunden ist, daß ein Ausgang des Flip-Flops (6) den Ausgang (11) der Schaltungsanordnung bildet und mit einem Eingang für die geringstwertige Binärstelle von Programmiereingängen (8) des Abwärtszählers (5) verbunden ist und daß weitere Binärstellen der Programmiereingänge von einer Quelle (9, 15) für eine das Teilerverhältnis darstellende Binärzahl steuerbar sind.

5. Schaltungsanordnung nach Anspruch 4, dadurch gekennzeichnet, daß der Ausgang des Flip-Flops (6) mit dem Eingang für die geringstwertige Binärstelle über eine Und-Schaltung (13) verbindbar ist, die ferner mit einem weiteren Ausgang (14) der Quelle (15) verbunden ist.

Fig.1

Fig.2

Fig.3